Europäisches Patentamt

European Patent Office

Office européen des brevets

(19)

(11) Veröffentlichungsnummer: **0 238 965**
**A2**

## (12) EUROPÄISCHE PATENTANMELDUNG

(21) Anmeldenummer: 87103784.2

(22) Anmeldetag: 16.03.87

(51) Int. Cl.⁴: **G03F 7/10**

(30) Priorität: 25.03.86 DE 3610087

(43) Veröffentlichungstag der Anmeldung:
30.09.87 Patentblatt 87/40

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Formanek, Helmut, Dr.**
**Römerhofweg 51**
**D-8046 Garching(DE)**
Erfinder: **Knapek, Erwin, Dr.**
**Franz-Schubert-Str. 26**
**D-8025 Unterhaching(DE)**

(54) **Elektronenstrahlempfindliches Resistmaterial für Mikrostrukturen in der Elektronik.**

(57) Das elektronenstrahlempfindliche Resistmaterial besteht aus mit Dotierungen versehenen Folien (5) aus Hochpolymeren, die aus den entsprechenden Lösungen durch Auftrocknen auf den aus halbleitenden oder piezoelektrischen Materialien bestehenden Substraten (3) erzeugt sind. Als dotierende Zusätze sind enthalten: Halogene, Halogenverbindungen, Peroxide, kaotrope Salze oder Xanthogenate. Das Resistmaterial wird verwendet zur Herstellung von elektronenstrahlgeschriebenen Mikrostrukturen mit hoher Strukturauflösung und erspart im Gegensatz zu den bekannten Verfahren den mit Fehlern behafteten Entwicklungsprozeß.

EP 0 238 965 A2

# Elektronenstrahlempfindliches Resistmaterial für Mikrostrukturen in der Elektronik.

Die Erfindumg betrifft ein elektronenstrahlempfindliches Resistmaterial zur Herstellung von auf Substraten aus halbleitenden oder piezoelektrischen Materialien erzeugten Mikrostrukturen in der Elektronik.

Elektronenstrahlempfindliche Resistmaterialien, welche zur Erzeugung von Mikrostrukturen in der Halbleitertechnologie für die Herstellung höchstintegrierter Schaltungen verwendet werden, sind zum Beispiel Polymethylmethacrylatlacke (PMMA). Diese Lacke, die in einem Aufsatz von H. W. Deckman und J. H. Dunsmuir in der Zeitschrift J. Vac. Sci. Technol. B1 (4), 1983, auf den Seiten 1166 bis 1170, näher beschrieben sind, werden in dünnen Schichten auf die Halbleitersubstrate aufgebracht, mittels eines Elektronenstrahls mit einer Struktur versehen und im Anschluß an die Bestrahlung einem Entwicklungsprozeß unterworfen, in welchem die als Maskierung dienende Lackstruktur erzeugt wird. Dabei treten folgende Probleme auf:

1. Es ist schwierig, eine reproduzierbare Schichtdicke einzustellen.

2. Aufgrund der Wechselwirkung der zu belichtenden Materie (zum Beispiel PMMA) mit - schreibenden Elektronenstrahl wird ein nachfolgender Entwicklungsprozeß notwendig, der mit erheblichen Fehlern behaftet ist.

Die Aufgabe, die der Erfindung zugrundeliegt, besteht in der Angabe eines elektronenstrahlempfindlichen Resistmaterials, welches diese Nachteile nicht aufweist; insbesondere soll aber der mit Fehlermöglichkeiten behaftete Entwicklungsprozeß umgangen werden.

Diese Aufgabe wird dadurch gelöst, daß als Resistmaterial mit Dotierungen aus Halogenen, Halogenverbindungen oder Peroxiden versehene Folien aus Hochpolymeren, die aus den entsprechenden Lösungen durch Auftrocknen auf den Substraten hergestellt sind, vorgeschlagen werden. Dabei können die Lösungen zusätzlich kaotrope Salze und/oder Xanthogenate enthalten. Die dotierten Folien können sowohl aus natürlichen (durch Biosynthese hergestellten), als auch aus künstlichen (durch künstliche Synthese und Polymerisation hergestellten) Hochpolymeren bestehen.

Weitere Ausgestaltungen der Erfindung ergeben sich aus den Unteransprüchen.

Folgende Überlegungen haben zur Erfindung geführt:
Aus dem Buch von L. Reimer: "Elektronenmikroskopische Untersuchungs-und Präparationsmethoden", Springer-Verlag, Berlin-Heidelberg-New York, 1967, Kapitel 15.6 sind auf den Seiten 330 bis 331 Verfahren bekannt, bei denen für die Durchstrahlungselektronenmikroskopie Lochfolien entwickelt worden sind, deren Lochdurchmesser von 10 nm bis 10000 nm variiert werden können. Diese Verfahren beruhen darauf, mit Hilfe von Elektronenstrahlen Löcher in vorbehandelte Kunststoff-Folien zu schießen, wofür Intensitäten von $10^{-5}$ bis $10^{-4}$ Coulomb/cm² hinreichend sein können.

Die Erfindung macht sich diese Erkenntnisse für die Herstellung von Mikrostrukturen zunutze und erhält ein völlig neuartiges Elektronenresist, nach dessen Herstellung auf dem Halbleitersubtrat als Folie sofort die Elektronenstrahlbehandlung erfolgen kann; ein nachfol gender Entwicklungsprozeß erübrigt sich.

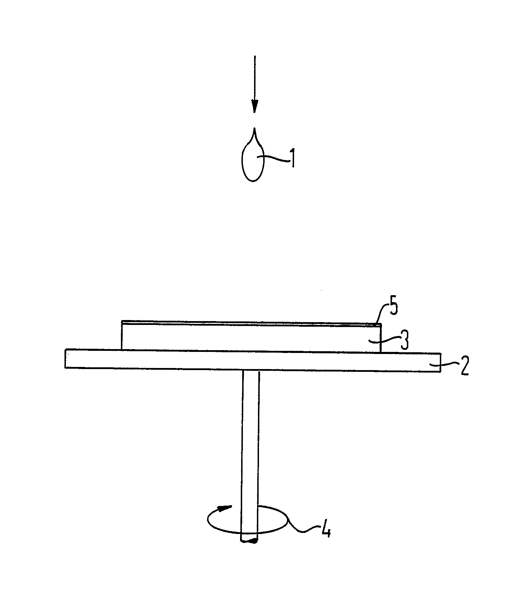

Die Erfindung wird im folgenden anhand eines Ausführungsbeispiels, welches die Herstellung einer dotierten Folie auf einem Halbleitersubstrat aus Silizium betrifft, anhand der Figur noch näher erläutert. Als Substrate können auch Kristallscheiben aus A$^{III}$ B$^{V}$ -Verbindungen oder aus piezoelektrischen Materialien wie zum Beispiel Lithiumniobat, wie es zur Herstellung von Oberflächenwellenfiltern verwendet wird, benutzt werden.

In einem organischen Lösungsmittel, zum Beispiel Aceton oder Äthanol, wird 0,1 bis 1 % eines Kunststoffes oder eines abgewandelten Naturstoffes, zum Beispiel Polyvinylformal oder Nitrozellulose, und 0,1 bis 1 % eines Dotierungsmittels, zum Beispiel Brom oder Caliciumrhodanit, gelöst. Der Zusatz von Halogenen (wie Chlor oder Brom) oder Halogenverbindungen (wie zum Beispiel Eisen-III-Chlorid) oder Peroxiden (wie zum Beispiel Dibenzoylperoxid) initiiert eine erhöhte Strahlempfindlichkeit; der Zusatz von kaotropen Salzen wie Calciumrhodanid stört hydrophobe Wechselwirkungen; der Zusatz von Xanthogenaten, wie zum Beispiel Kaliumxanthogenat, suspendiert Zellulose.

Die das Dotierungsmittel in einer bestimmten Konzentration enthaltende hochpolymere Lösung 1 wird nun in einer definierten Menge auf den, auf einem Substrathalter 2 befindlichen Siliziumsubstratscheiben 3 aufgebracht. Der Substrathalter 2 ist mit einer Lackschleuder (siehe Drehpfeil 4) gekoppelt. Die Lösung 1 wird auf dem Substrat 3 getrocknet und die auf der Oberfläche des Substrates 3 entstehende Resistfolie 5 kann dann sofort der Elektronenstrahl-Belichtung zugeführt werden. Die Schichtdicke der Folie 5 ergibt sich aus der Menge der aufgebrachten hochpolymeren, dotierten Lösung 1 und der Schleudergeschwindigkeit der Schleuder 4.

Gegenüber der herkömmlichen Lackbeschichtung von Halbleitersubstraten bieten die erfindungsgemäßen Beschichtungen mit Folien aus Kunststoffen oder Zellulosederivaten folgende Vorteile:

1. Eine gleichmäßig-dicke Beschichtung ist durch Variation der Konzentration der Folienmaterialien in verschiedenen Lösungsmitteln leicht erzielbar.

2. Aufgrund der Sublimation von Folienmaterial im schreibenden Elektronenstrahl kann der mit Fehlermöglichkeiten behaftete Entwicklungsprozeß, der bei herkömmlicher Resiststrukturierung notwendig ist, vermieden werden.

3. Durch Variation der Dotierungsmittel ist die Möglichkeit gegeben, die Empfindlichkeit gegenüber Elektronenstrahlen zu erhöhen.

4. Es ist möglich, Linienbreiten bis herab zu 10 nm mit dem Elektronenstrahl zu schreiben.

5. Die Herstellung reproduzierbarer unterschiedlicher Foliendicken durch Variation der Konzentrationen der Folienmaterialien in den verschiedenen Lösungsmitteln ist realisierbar.

Bezugszeichenliste

1 Kunststofflösung
2 Substrathalter
3 Substratscheiben
4 Lackschleuder
5 Resistfolie

## Ansprüche

1. Elektronenstrahlempfindliches Resistmaterial (5) zur Herstellung von auf Substraten (3) aus halbleitenden oder piezoelektrischen Materialien erzeugten Mikrostrukturen in der Elektronik, **gekennzeichnet durch** mit Dotierungen aus Halogenen, Halogenverbindungen oder Peroxiden versehenen Folien (5) aus Hochpolymeren, die aus den entsprechenden Lösungen (1) durch Auftrocknen auf den Substraten (3) hergestellt sind.

2. Resistmaterial nach Anspruch 1, **dadurch gekennzeichnet**, daß die Lösungen (1) zusätzlich kaotrope Salze und/oder Xanthogenate enthalten.

3. Resistmaterial nach Anspruch 1 und/oder 2, **dadurch gekennzeichnet**, daß die Schichtdicke der Folien (5) in Abstimmung auf die Art und Konzentration der verwendeten Dotierung 10 bis 1000 nm beträgt.

4. Resistmaterial nach mindestens einem der Ansprüche 1 bis 3, **dadurch gekennzeichnet,** daß die dotierten Folien (5) sowohl aus natürlichen, als auch aus künstlichen Hochpolymeren bestehen.

5. Resistmaterial nach Anspruch 4, **dadurch gekennzeichnet**, daß die dotierten Folien (5) als hochpolymeren Bestandteil Polyvinylformal oder Nitrocellulose oder Acetylcellulose oder deren Derivate enthalten.

6. Resistmaterial nach mindestens einem der Ansprüche 1 bis 5, **dadurch gekennzeichnet,** daß als dotierende Halogene Brom und/oder Jod, als Halogenverbindungen Eisen-III-Chlorid und als dotierende Peroxide Dibenzoylperoxid enthalten sind.

7. Resistmaterial nach mindestens einem der Ansprüche 1 bis 6, **dadurch gekennzeichnet ,** daß als kaotropes Salz Calciumrhodanid zugesetzt ist.

8. Resistmaterial nach mindestens einem der Ansprüche 1 bis 7, **dadurch gekennzeichnet,** daß als Xanthogenat Kaliumxanthogenat verwendet ist.

9. Verfahren zur Herstellung des elektronenstrahlempfindlichen Resistmaterials nach mindestens einem der Ansprüche 1 bis 8, **dadurch gekennzeichnet,** daß

a) der hochpolymere Kunst-oder Naturstoff in einem organischen Lösungsmittel in einer Konzentration im Bereich von 0,1 bis 1 % gelöst wird,

b) die Lösung mit dem Dotierzusatz oder den Dotierzusätzen in einer Konzentration im Bereich von 0,1 bis 1 % versehen wird und

c) die dotierte Kunststofflösung (1) in der, entsprechend der gewählten Schichtdicke angepaßten Menge auf die Oberfläche des Substrates (3) aufgetropft und in Folienform (5) zum Trocknen veranlaßt wird.

10. Verfahren nach Anspruch 9, **dadurch gekennzeichnet,** daß während des Auftropfens der Lösung (1) der Substrathalter (2) mit den Substraten (3) in Schleuderbewegung (4) versetzt wird.

11. Verfahren nach einem der Ansprüche 9 oder 10, **dadurch gekennzeichnet,** daß als Lösungsmittel Aceton oder Äthanol verwendet wird.